# EUROPEAN PATENT APPLICATION

(11) **EP 4 191 643 A1**
(43) Date of publication of application: **07.06.2023**
(21) Application number: 21211895.4
(22) Date of filing: 02.12.2021
(51) Int. Cl.: H01L 21/60, H01L 21/56, H01L 23/48, H01L 23/31

(54) **METHOD OF FORMING AN INTERCONNECT METALLISATION BY PANEL LEVEL PACKAGING AND THE CORRESPONDING DEVICE**

(71) Applicant: Nexperia B.V., 6534 AB Nijmegen (NL)
(72) Inventor: Flauta, Randolph Estal, 6534AB Nijmegen (NL); Kan, Wae Lam, 6534AB Nijmegen (NL); Hor, Wai Hung William, 6534AB Nijmegen (NL); Zhou, Zhou, 6534AB Nijmegen (NL)
(74) Representative: Pjanovic, Ilija

(57) **Abstract**

A method of packaging a semiconductor die, the method comprising the steps of providing a semiconductor die (13) onto a substrate , wherein said substrate comprises a carrier layer (11) with a release tape (15) situated thereon, wherein a bottom side of said semiconductor die (13) is placed on said thermal release tape (15), such that placement of said semiconductor die (15) forms a first raised surface and a second surface; application of a photoresist layer (21) on both said semiconductor die (13) as well as said thermal release tape (15); formation of openings (27, 29) in said photoresist layer (21) so as to expose said semiconductor die (13) above said first surface and to partially expose, adjacent to said semiconductor die (13), said thermal release tape (15) above said second surface; formation of a metallization layer (5,31) such that said metallization layer (5,31) contacts said exposed semiconductor die (13) above said first surface and said partially exposed thermal release tape (15) adjacent to said semiconductor die (13); encapsulating said semiconductor die (13) as well as said thermal release tape (15) with an insulating layer (3); removal of said substrate (11) along with said thermal release tape (15) so as to reveal said metallization layer (5,31) adjacent to said semiconductor die (13), and said bottom side of said semiconductor die (13); and metallization (49) of said bottom side of said semiconductor die (13) to form said packaged semiconductor die. A corresponding device is also presented herein.

## Description

### Technical Field

The present application generally relates to the field of electronics and more specifically to new packaging concept for a semiconductor die

### Background

In the current electronics industry, there has been a continuing trend of miniaturization together with the need for cost effective manufacturing methods. In the traditional power packaging using a clip and a lead frame, build up stress are induced during the curing process at joint interfaces such as epoxy in between lead frame and die and solder epoxy between the semiconductor die and clip. These build up stresses are carried throughout the assembly processes. The affected areas become the initiation sites for failures, for example due to solder joint fatigue during temperature cycling. On larger dies, this build-up stress will increase the propensity for nitride passivation/die cracking.

In the current market solution such as those offered by Siptory, the die is attached to a pad forming a joint interface. Subsequently, both the die pad and lead pads are separated and connected through via holes drilled using a laser.

A similar solution is also described in US patent application US 2020/0312799 which claims a Triode packaging method. The end product as shown in the document has a strippable carrier which was covered with another metal layer, that serves as the bond pad, and protective film covering to prevent electroplating on the other areas. Subsequently, the die is "welded" on the bonding pad forming a triode template. A hole is drilled through the mould encapsulant to form aperture openings to contact leads and the die bond pads to form a "closed-loop circuit". According to this document, to form the "closed loop circuit" (interconnect), through holes were made to the encapsulated die for subsequent electroplating onto the via and the top flat surface of the mould surface.

US patent application US 2002/01066879 also proposes a multilayer structure having a dielectric layer formed over the metal layer and a metal spacer formed on the sidewall of the aperture. However, such a method is implemented at wafer level fabrication.

Thus, there is a need to develop a cost-efficient method of packaging a semiconductor die that results in an end product that is less susceptible to joint stress while eliminating the necessary Bill of Materials, BoM, such as leadframe carrier and die attach epoxy.

### Summary

A summary of aspects of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

In a first aspect of the present disclosure, there is presented a method of packaging a semiconductor die, the method comprising the steps of providing a semiconductor die onto a substrate, wherein said substrate comprises a carrier layer with a release tape situated thereon, wherein a bottom side of said semiconductor die is placed on said thermal release tape, such that placement of said semiconductor die forms a first raised surface and a second surface, application of a photoresist layer on both said semiconductor die as well as said thermal release tape.

In a further step of the method, openings are formed in said photoresist layer so as to expose said semiconductor die above said first surface and to partially expose, adjacent to said semiconductor die, said thermal release tape above said second surface, and on top thereof a metallization layer is formed such that said metallization layer contacts said exposed semiconductor die above said first surface and said partially exposed thermal release tape adjacent to said semiconductor die.

In a subsequent step, the semiconductor die as well as said thermal release tape with an insulating layer is encapsulated, and thereafter, the substrate along with said thermal release tape is removed so as to reveal said metallization layer adjacent to said semiconductor die, and said bottom side of said semiconductor die with Backside Metallization, BSM.

As a subsequent step the bottom side of said semiconductor die is further metallized to form said packaged semiconductor die.

In the present disclosure, a substrate comprised of a glass or composite carrier and a temperature sensitive tape is used to reconstruct the die. As opposed to the solutions known from the prior art, the dies are not "welded" so there is no die attach compound such as epoxy being used. In the present disclosure, a "step" interconnect is formed over a patterned photoresist through the apertures, with the metallization formed through the die sidewalls covered with resist.

The present disclosure discloses a step metallization structure made by depositing a 3D metallization structure on the exposed die bond pad following the contour of an insulated die sidewall and down to the first surface to form the contact leads. The multilayer metallization structure in prior art is used at wafer-level fabrication. The invention enables implementation at assembly packaging level.

After mould encapsulation - through the heat sensitive tape, carrier is separated from the moulded components. To ensure good adhesion of the photoresist to the moulding compound, plasma treatment can be made prior to moulding.

This disclosure relates to a new package concept that eliminates the need for epoxy or epoxy solder used in traditional clip/lead frame-based power packages. This disclosure will overcome this inherent disadvantage in clip-based packages by depositing the interconnect structure directly to the bod pads. The formation of the interconnect done at lower temperature leads to lower stress induced onto the die. The presence of photoresist serves as a buffer layer between the EMC and the die area to further mitigate nitride passivation/die cracking.

An advantage of the present disclosure is that semiconductor dies packaged using a method according to the present disclosure will have smaller footprint as the pads are directly built up/deposited. This disclosure also relates to low-cost packaging as the processes required allows large area processing i.e. panel level processing, PLP. Moreover, the invention eliminates several packaging materials which are the main cost runners for Die-Free Package Cost, DFPC, i.e. clip and lead frame, and die attach and clip attach epoxy/solder materials and its corresponding processes such as clip and die attach, solder reflow. This invention will use photoresist typically used in PCB manufacturing.

A step interconnect metallization, SIM, layer is formed on the photoresist aperture/openings of die bond pad and contact leads. The interconnect is formed via seed layer deposition and electroplating. The method eliminates the need for epoxy or epoxy solder used in traditional packages. The present disclosure employs depositing the interconnect structure directly to bond pads. This step can be done at a lower temperature leading to lower stress induced in the die.

A new package concept and methods are disclosed that enables the direct formation of 3D metallization contacts connecting the bonding pads through the die sidewall down to the contact leads. The die attachment, moulding/encapsulation, and formation of contacts are made through a temporary/reusable carrier. This novel package avoids the following major bill of materials: clip frame and lead frame, die attach epoxy and clip attach solder epoxy, and their corresponding processes. The package has reduced build-up stress as it eliminates the curing processes needed in the formation of the joint interfaces. This new package concept and processes are compatible for large panel level processing, PLP, further reducing the overall package cost.

According to an example, the method also comprises the steps of exposing said semiconductor die covered with photoresist to Ultra Violet, UV light to form window pads; and depositing seed layer and electroplating a further metallic layer to form the step interconnect. This step is performed to the metallized bottom side as well as said revealed metallization layer adjacent to said semiconductor die. These steps may be performed to cure the additional insulation layer at the bottom of the semiconductor die and to form openings thereon allowing contact pads to be formed at a bottom part of the packaged semiconductor die.

In an exemplary embodiment, the first metallization layer of the step interconnect is formed by seed layer deposition. For example, seed layer deposition is implemented either by laser induced metallization or by shadow mask sputtering. Such methods are well known to the skilled person and thus allow integration of existing methods to achieve the packaged semiconductor die according to the present disclosure.

According to an example, the method further comprises the step of providing a further photoresist layer on said metallized bottom side as well said revealed metallization layer adjacent to said semiconductor die. The further photoresist layer or insulation layer will be beneficial to insulate multiple contacts that need to be formed on the bottom side of the semiconductor die.

At the bottom side, said step of electroplating a Copper, Cu, layer and further metallic layer uses Tin, Sn, as the metal. This may be needed to achieve better adhesion of the bottom contact pad layer to solder when mounted on a PCB. The skilled person understands that electroplating may also be employed to deposit the metallic contacts.

According to an example, the further metallization of said bottom side of said semiconductor die is performed by electroplating.

According to an exemplary embodiment, the first surface of said semiconductor die comprises two separate regions, and wherein said step of formation of openings, forms separate openings corresponding to each of said two separate regions above said semiconductor die as well as adjacent to said semiconductor die, and further wherein during said step of forming a metallization layer, two separate metallization layers are formed wherein each of said two separate metallization layers contacts corresponding openings above said semiconductor die as well as adjacent to said semiconductor die.

Such structure may be needed to form a packaged three terminal device such a as Metal Oxide Semiconductor Field Effect Transistor, MOSFET, device. In such a case, for example, the source and the gate are located on the two separate regions on the first surface of the semiconductor die and the drain is formed on the bottom part of the semiconductor die. The skilled person understands that the steps of the method presented in the first aspect of the present disclosure may be extended to multiple input multiple output device such as ICs as well.

According to an example, the photoresist layer is applied by spray coating.

According to an exemplary embodiment, the method further comprises the step of cutting said packaged semiconductor die to form individual packaged semiconductor components. Such a step is known as singulation and may be needed to form individual components. A key advantage of the method according to the present disclosure is that it allows large scale, i.e. panel level processing. Such a panel may comprise multiple ICs, or transistor or any other semiconductor devices. Consequently, to obtain an end product cutting the dies may be required to end up with individual component that can be used in a circuit.

In a second aspect of the present disclosure, there is presented a packaged semiconductor die, said semiconductor die having a top surface, a bottom surface, and sides wherein said packaged semiconductor die comprises a photoresist layer on said top surface, said sides and on extending adjacent to said semiconductor die co-planar to said bottom surface; openings in photoresist layer arranged above said top surface and adjacent to said semiconductor die co-planar to said bottom surface; a stepped interconnect metallization layer, connecting said semiconductor die at said opening in photoresist layer arranged above said top surface with a metallic contact via said opening adjacent to said semiconductor die co-planar to said bottom surface; a further metallic contact on said bottom surface of said semiconductor die that contacts the semiconductor die.

It is noted that the advantages and definitions associated with the first aspect of the present disclosure being a method of packaging a semiconductor die is also associated with the second aspect of the present disclosure being the packaged semiconductor die.

According to an exemplary embodiment, the packaged semiconductor die is a Metal Oxide Semiconductor Field Effect Transistor, MOSFET, device.

According to an embodiment, the packaged semiconductor die is a Multiple Input Multiple Output, MIMO, device.

### Brief description of the drawings

Fig. 1 illustrates a packaged semiconductor die according to one aspect of the present disclosure.
Fig. 2 illustrates a packaged semiconductor die according to one aspect of the present disclosure.
Figures 3 and 4 schematically illustrate a semiconductor die according to an embodiment of the present disclosure.
Figures 5 through 19 schematically illustrate the various steps involved in a method of packaging a semiconductor die according to the present disclosure.

### Detailed Description

The ensuing description above provides preferred exemplary embodiment(s) only, and is not intended to limit the scope, applicability or configuration of the invention. Rather, the ensuing description of the preferred exemplary embodiment(s) will provide those skilled in the art with an enabling description for implementing a preferred exemplary embodiment of the invention, it being understood that various changes may be made in the function and arrangement of elements, including combinations of features from different embodiments, without departing from the scope of the invention.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the Detailed Description using the singular or plural number may also include the plural or singular number respectively. The word "or," in reference to a list of two or more items, covers all of the following interpretations of the word: any of the items in the list, all of the items in the list, and any combination of the items in the list.

The teachings of the technology provided herein can be applied to other systems, not necessarily the system described below. The elements and acts of the various examples described below can be combined to provide further implementations of the technology. Some alternative implementations of the technology may include not only additional elements to those implementations noted below, but also may include fewer elements.

These and other changes can be made to the technology in light of the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the Detailed Description section explicitly defines such terms. Accordingly, the actual scope of the technology encompasses not only the disclosed examples, but also all equivalent ways of practicing or implementing the technology under the claims.

The present disclosure is described in conjunction with the appended figures. It is emphasized that, in accordance with the standard practice in the industry, various features are not drawn to scale. In fact, the dimensions of the various features may be arbitrarily increased or reduced for clarity of discussion.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

The disclosure in the present application relates to a step interconnect metallization, SIM, package by forming an insulating structure traversing from the die top and its sidewall to the bottom contact leads, Apertures/openings are made on the bond pads of the source and the gate to enable connection to the contact leads. The insulator 15 is formed over the reconstituted die 13 top, sidewall and contact lead areas to form a step insulation 15, 31. Alternative insulator can be used such as dielectrics which can be realized using Plasma Enhanced Chemical Vapor Deposition, PECVD, or Plasma Enhanced Atomic Layer Deposition, PE-ALD. Polyimide can also be used as another alternative insulator and can be deposited by using Vapor deposition Polymerization, VPD.

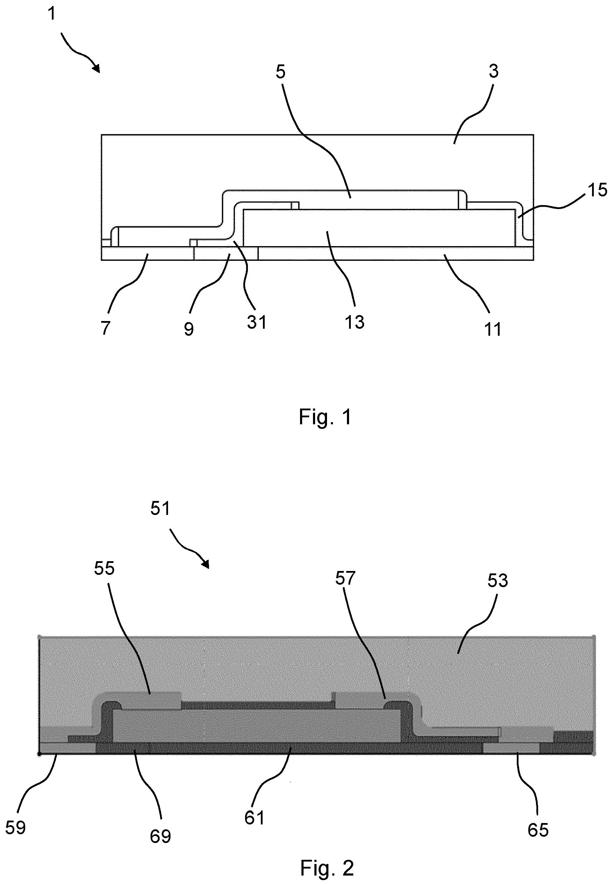

For the present disclosure, insulation using a photoresist is described. A step metallization is deposited making connection from gate/source pads to contact leads at the bottom of the package as depicted in Fig. 1. Photoresist 9 at the bottom part of the package separates the contact leads 7, 11 and provides additional protection at the bottom part of the die.

While Figure 1 shows a packaged die 1 according to one aspect of the present disclosure, wherein the device is a three terminal MOSFET device. For example, the contact lead 11 is a drain terminal and contact 7 is source terminal. The gate terminal (not shown) may be located behind the source terminal. The skilled person understands that the method according to the present disclosure, the device may also be a Multiple Input Multiple Output, MIMO, device such as an Integrated Circuit, IC as shown in Figure 2.

In Fig. 2, reference numeral 51 indicates a packaged semiconductor die, enclosed within a protective mould 53. It has step metallic interconnects 55 and 57 which originate on the top part of the die and follow the contour of the die in a stepped manner so as to enable electrical contact between the top part of the die and the contact pads 59, 65 which sit flush with the bottom part of the die. Adjacent to the contact lead 59, 65, an additional photo resist layer or insulation layer 61 ensures that several contacts disposed on the bottom surface do not create a short circuit. Reference numeral 69 indicates a connector suitable for electroplating

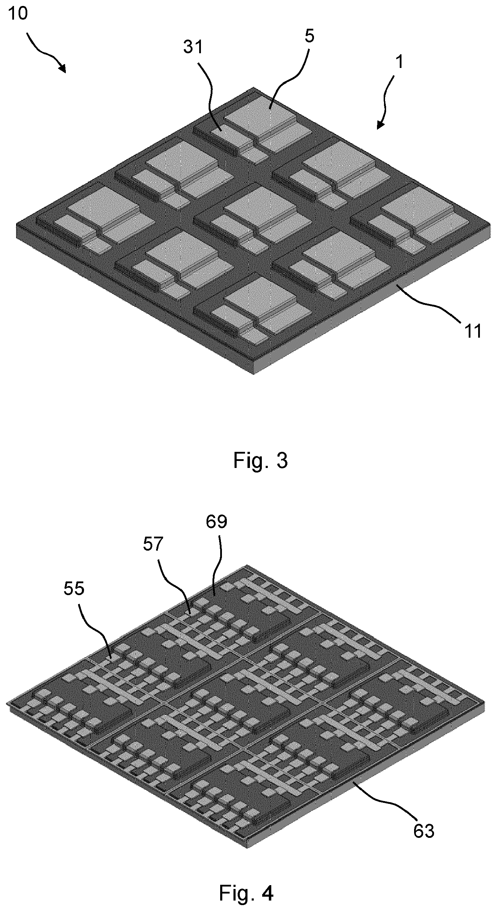

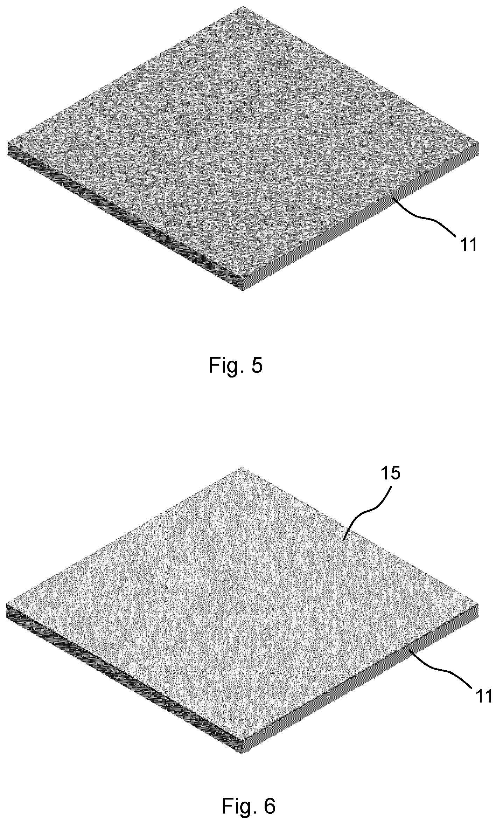

While Figures 1 and 2 illustrate a cross section of the packaged semiconductor die, Figures 3 and 4 illustrate a panel comprising a plurality of such dies in three-dimensional, 3D, layout thereby enabling better understanding. The individual components are further elaborated with the help of figures 5 - 19 showing the intermediate steps involved in the packaging of a semiconductor die according to the present disclosure. Furthermore, it is noted that while the method steps are primarily explained with the intention of packaging a MOSFET device, the skilled person understands that the same or similar steps can be applied to other semiconductor device as well to achieve a similar packaging and similar advantages.

In a first step, as shown in Figure 5, a panel 11 of reusable material such as glass or composite material can be used as a carrier where the dies are to be reconstructed. The skilled person understands that although it is not important that the panel has to be of a reusable material, but this may be desirable from an economic perspective. For example, the panel may be made of Silicon. As will be evident from the subsequent steps, since this layer will be removed, it may be beneficial to employ a reusable layer. The panel of the reusable layer has standard dimensions as known in the field. For example, the panel has dimensions of 600mm x 600mm.

Fig. 6 shows the subsequent step after application of heat sensitive or thermal release tape 15 on top of carrier 11 as shown in Fig. 5. The tape will be chosen depending upon the mould temperature requirements. Such a heat sensitive or thermal release tape is generally known in the field of die packaging and several examples are commercially available. An important feature of such tapes is that they adhere to a first surface when raised to a first temperature and can be removed from said first surface when heated to a second temperature which is usually higher than the first temperature. For example, heating the carrier layer to 70° C results in adhesion of the tape onto the carrier layer and subsequently, heating the layer to 200° C results in the release of the thermal tape from the carrier layer.

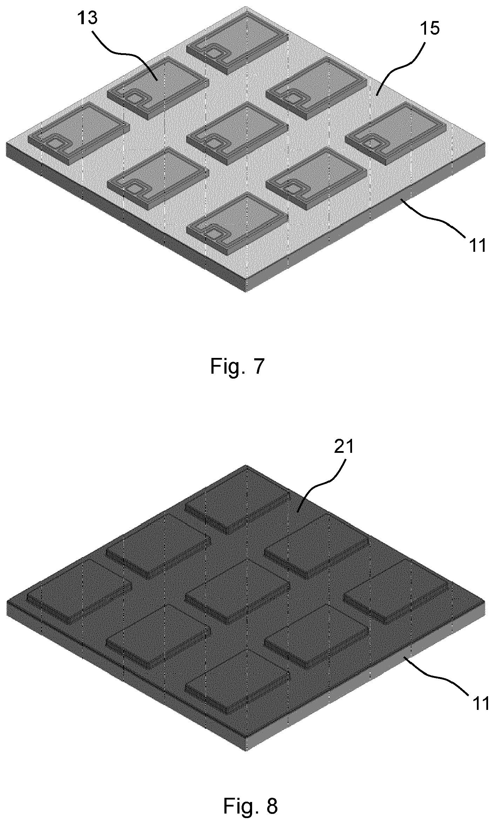

Fig. 7 shows the carrier after reconstruction of die 13 on the carrier 11/ tape 15. The heat sensitive tape 15 which is readily available in the market used in Fan Out Wafer Level Packaging, FOWLP, or Fan Out Panel Level Packaging, FOPLP, is laminated on the carrier 11 and the dies 13 are picked and placed onto the tape 15. Placement tolerance can be as low as ∼25um using pick and place machines available in the market.

In a subsequent step, as shown in Fig. 8, the Photoresist, PR, 21 is applied on the entire area by spray coating covering both the die and carrier surfaces.

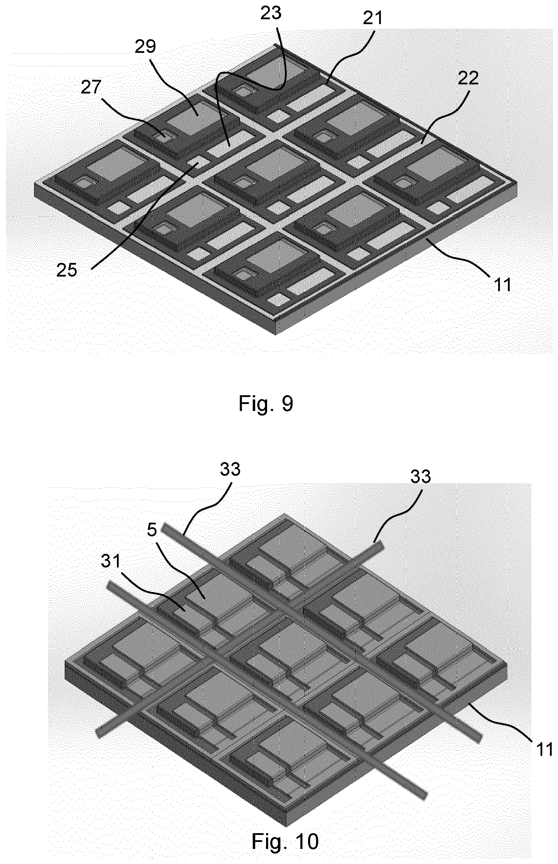

Fig. 9 shows the carrier after UV exposure, development and curing. Alternatively, for larger die with larger contact pads, cheaper solder mask can also be applied via stencil printing. At the end of this step, contact pads 27, 29 are formed on a top part of the die exposing partially, the semiconductor die and the top part of the die being at least partially covered with the photoresist layer/insulating material 21. The step also exposes corresponding contact pads 23, 25 above the carrier layer, adjacent to the semiconductor die that partially exposes the thermal release tape on the carrier. It may be understood that the contact pads 23, 25, 27, 29 are, for example, gate/source pads. Fig. 9 also shows aperture windows with interconnecting lines 22. The interconnecting lines allow for electroplating instead of electroless plating.

Fig. 10 shows the carrier 11 after formation of metallization layer 5, 31 following the contour of the insulated die. From a study of the figures 9 and 10, the skilled person understands that the opening 29 is connected with a corresponding opening 23 by the metallic contact 5 and opening 27 with a corresponding opening 25 with by the metallic contact 31. The aperture/openings of the die pads and contact leads are interconnected through seed layer deposition and subsequently electroplating. The seed layer deposition can be implemented via laser induced metallization, LIM, or shadow mask sputtering, SMS, before electroplating. Fig . 10 also shows singulation lines 33 that may be formed. The singulation lines 33 enable the packaged die to be cut along these lines to get the final packaged semiconductor die.

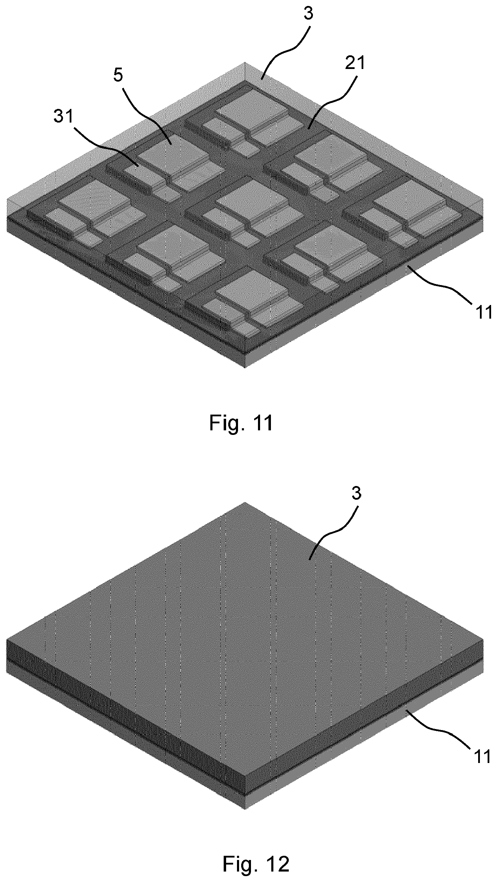

Fig. 11 shows an intermediate step of forming the packaged semiconductor die after mould 3 encapsulation. It will be appreciated that Figure 11 shows the mould 3 in a transparent manner so that the skilled person can visualize how the mould is placed. Fig. 12 shows the same step wherein the mould 3 is no longer visualized transparently.

After placing the mould, through the heat sensitive tape 15, the carrier 11 is separated from the moulded components. As explained previously, this is usually achieved by heating the moulded components to a predefined temperature such that the thermal release tape 15 loses its adhesion with the carrier layer 11. Such a process is known in the technical field.

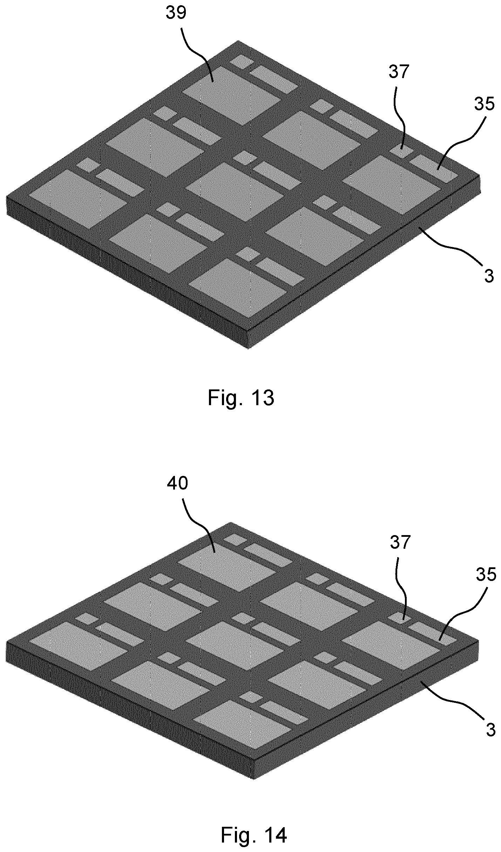

Fig. 13 shows an intermediate step of forming the packaged semiconductor die after removal of moulded die from carrier showing the bottom pad of the die and the contact leads 35, 37. It is further provided that the figure illustrates the die after being flipped to reveal the bottom pad of the dies and the contact leads. It will be understood that the contact leads 35, 37 are metallic. However, the semiconductor die is partially exposed via opening 39. This is subject to a further metallization so as to provide a further contact lead as shown in Fig. 14.

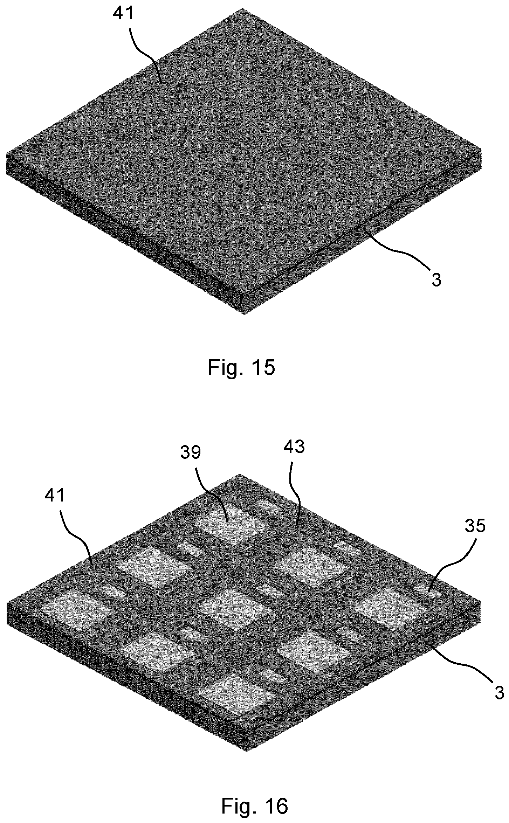

Reference is now made to Figures 14, 15 and 16. Fig. 14 shows the additional package protection, redistribution and formation of 2nd metal layer 40. After additional application of photoresist 41, UV exposure, and development, additional metallization layer 40 is formed on the die backside and the contact leads. A can be seen in Fig. 16, this step also, at least partially, exposes the bottom pads 43 so as to form the metallization layer. To achieve better adhesion of the bottom contact pad layer, Cu is first electroplated onto the pad and leads before applying another layer of photoresist & UV exposure to form the final window pads. And then the final layer is electroplated (e.g. Sn).

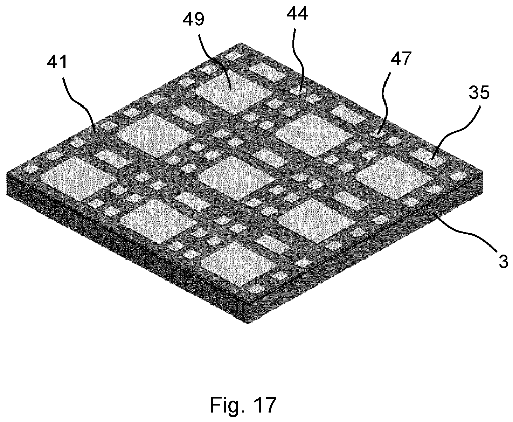

Fig. 17 shows a the final packaged semiconductor die product before any eventual singulation after the final electroplating layer has been applied. Thus metallic contacts 44 and 47 are formed together with the metallic contact for the semiconductor die itself, 49. If for example, the semiconductor die being packaged is a MOSFET device, the contacts could be, for example, source 44, gate 47 and drain 49.

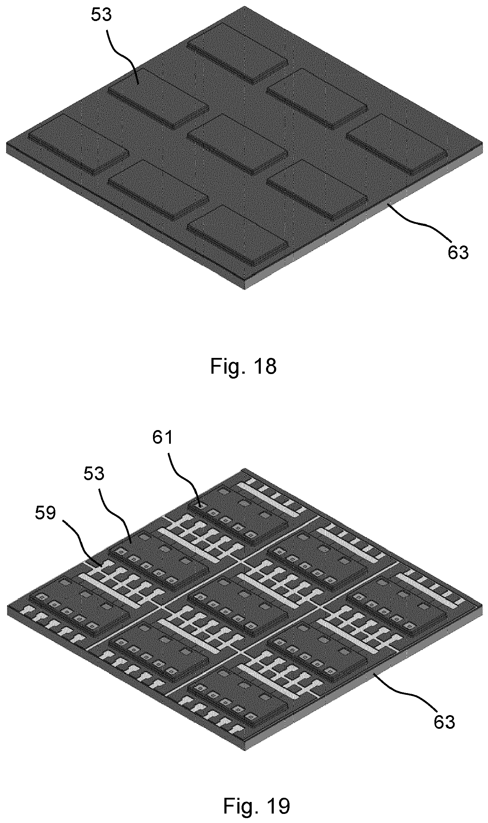

Figures 18, and 19 together with Figure 4 show the intermediate steps in the packaging method according to the present disclosure, when the device is a MIMO IC device. As shown in Fig. 18, the dies are placed on the carrier layer 63. It is understood that, as explained previously, the carrier layer is usually coated first with a thermal release tape. The illustration shown in Fig. 18 shows the dies as placed on the carrier/tape configuration that are subsequently coated with an insulation layer. The skilled person understands that Fig. 18 corresponds to Fig. 8 as previously illustrated and explained.

Fig. 19 shows the die as shown in Fig. 18 after it has been exposed to UV and is subject to development and curing and formation of apertures 59, 61 as needed for the MIMO device being packaged.

As illustrated in Fig. 4, step interconnect 55, 57 are formed that interconnect the formed apertures 59, 61.

In the description above, for the purposes of explanation, numerous specific details are set forth in order to provide a thorough understanding of implementations of the disclosed technology. It will be apparent, however, to one skilled in the art that embodiments of the disclosed technology may be practiced without some of these specific details.

The techniques introduced herein can be embodied as special-purpose hardware (e.g., circuitry), as programmable circuitry appropriately programmed with software and/or firmware, or as a combination of special-purpose and programmable circuitry. Hence, embodiments may include a machine-readable medium having stored thereon instructions which may be used to program a computer (or other electronic devices) to perform a process. The machine-readable medium may include, but is not limited to, floppy diskettes, optical disks, compact disc read-only memories (CD-ROMs), magneto-optical disks, ROMs, random access memories (RAMs), erasable programmable read-only memories (EPROMs), electrically erasable programmable read-only memories (EEPROMs), magnetic or optical cards, flash memory, or other type of media / machine-readable medium suitable for storing electronic instructions. The machine-readable medium includes non-transitory medium, where non-transitory excludes propagation signals. For example, a processor can be connected to a non-transitory computer-readable medium that stores instructions for executing instructions by the processor.

## Claims

**1.** A method of packaging a semiconductor die, the method comprising the steps of:
- providing a semiconductor die onto a substrate, wherein said substrate comprises a carrier layer with a release tape situated thereon, wherein a bottom side of said semiconductor die is placed on said thermal release tape, such that placement of said semiconductor die forms a first raised surface and a second surface;
- application of a photoresist layer on both said semiconductor die as well as said thermal release tape;
- formation of openings in said photoresist layer so as to expose said semiconductor die above said first surface and to partially expose, adjacent to said semiconductor die, said thermal release tape above said second surface;
- formation of a metallization layer such that said metallization layer contacts said exposed semiconductor die above said first surface and said partially exposed thermal release tape adjacent to said semiconductor die;
- encapsulating said semiconductor die as well as said thermal release tape with an insulating layer;
- removal of said substrate along with said thermal release tape so as to reveal said metallization layer adjacent to said semiconductor die, and said bottom side of said semiconductor die;
- metallization of said bottom side of said semiconductor die to form said packaged semiconductor die.

**2.** Method according to claim 1 further comprising a step of:
- providing a further photoresist layer on said metallized bottom side as well said revealed metallization layer adjacent to said semiconductor die.

**3.** Method according to claim 2, further comprising the steps of:
- exposing said semiconductor die covered with photoresist to Ultra Violet, UV light to form window pads; and
- electroplating a further metallic layer to metallized bottom side as well as said revealed metallization layer adjacent to said semiconductor die.

**4.** Method according to claim 3, wherein said step of metallization uses Copper as the metal, and wherein said step of electroplating a further metallic layer uses Tin as the metal.

**5.** Method according to any of the previous claims wherein the initial metallization layer is formed by seed layer deposition and a further metallization layer is formed by electroplating.

**4.** Method according to claim 5, wherein said seed layer deposition is implemented either by laser induced metallization or by shadow mask sputtering.

**6.** Method according to any of the previous claims wherein said metallization of said bottom side of said semiconductor die is performed by electroplating.

**7.** Method according to any of the previous claims wherein said first surface of said semiconductor die comprises two separate regions, and wherein said step of formation of openings, forms separate openings corresponding to each of said two separate regions above said semiconductor die as well as adjacent to said semiconductor die, and further wherein during said step of forming a metallization layer, two separate metallization layers are formed wherein each of said two separate metallization layers contacts corresponding openings above said semiconductor die as well as adjacent to said semiconductor die.

**8.** Method according to claim 7, wherein said method forms a packaged semiconductor die with three terminals.

**9.** Method according to any of the previous claims wherein said photoresist layer is applied by spray coating.

**10.** Method according to any of the previous claims, further comprising the step of cutting said packaged semiconductor die to form individual packaged semiconductor components.

**11.** A packaged semiconductor die, said semiconductor die having a top surface, a bottom surface, and sides wherein said packaged semiconductor die comprises:
- a photoresist layer on said top surface, said sides and on extending adjacent to said semiconductor die co-planar to said bottom surface;
- openings in photoresist layer arranged above said top surface and adjacent to said semiconductor die co-planar to said bottom surface;
- a stepped interconnect metallization layer, connecting said semiconductor die at said opening in photoresist layer arranged above said top surface with a metallic contact via said opening adjacent to said semiconductor die co-planar to said bottom surface;
- a further metallic contact on said bottom surface of said semiconductor die that contacts the semiconductor die.

**12.** The packaged semiconductor die according to claim 11, wherein said packaged semiconductor die is a Metal Oxide Semiconductor Field Effect Transistor, MOSFET, device.

**13.** The packaged semiconductor device according to claim 11, wherein said packaged semiconductor die is a Multiple Input Multiple Output, MIMO, device.
